# EUROPEAN PATENT APPLICATION

(11) **EP 1 578 186 A2**
(43) Date of publication of application: **21.09.2005**
(21) Application number: 05003908.0
(22) Date of filing: 23.02.2005
(51) Int. Cl.: H05K 13/08

(54) **Inspection method and system and production method of mounted substrate**

(30) Priority: 01.03.2004 JP 2004056757; 17.02.2005 JP 2005040703
(71) Applicant: OMRON CORPORATION, Kyoto 600-8530 (JP)
(72) Inventor: Ishiba, Masato c/o Omron Corporation, Shiokoji-dori Kyoto-shi Kyoto 600-8530 (JP); Kuriyama, Jun c/o Omron Corporation, Shiokoji-dori Kyoto-shi Kyoto 600-8530 (JP); Murakami, Kiyoshi c/o Omron Corporation, Shiokoji-dori Kyoto-shi Kyoto 600-8530 (JP); Yotsuya, Teruhisa c/o Omron Corporation, Shiokoji-dori Kyoto-shi Kyoto 600-8530 (JP)
(74) Representative: Kilian, Helmut

(57) **Abstract**

Substrates with components mounted thereon are produced by a plurality of sequentially performed production steps. Inspection apparatus (1A-1D) are provided, each associated with different one of these production steps including the last step. These inspection apparatus communicate among themselves and each use an image of a target substrate to be inspected taken after or data obtained in an earlier executed production step.

## Description

### Background of the Invention

This invention relates to a method and a system of inspection in the production of substrates each having components mounted thereonto. The production process includes a plurality of steps but an inspection is carried out at the end of the last of the production steps or in a plurality of steps including the last production step by an image processing process. The invention also relates to a production method of such mounted substrates by carrying out such inspection processes.

Examples of common production step for mounted substrates include the solder printing step for printing cream solder on a printed circuit board, the component mounting step for mounting components at positions where cream solder has been applied and the soldering step for heating the substrate after the component mounting step has been carried out so as to attach the mounted components onto the substrate. The production line for carrying out these steps in a series is sometimes provided with inspection apparatus for inspecting the external view of each substrate after each step such that substrates having a defect generated in the associated production step can be removed from the production line and will not be allowed to be transported downstream.

Japanese Patent Publication Tokkai 11-298200 discloses such an inspection system for substrates, provided with inspection apparatus for each production step, each of these inspection apparatus being connected to a host computer (serving as a process control apparatus) and adapted to transmit the results of inspection and various measured data obtained by the inspection to this host computer. The process control apparatus is provided with the function of analyzing whether or not there is a correlation among the measured data obtained from the inspection apparatus that may be causing the occurrence of defects among the products.

The inspection apparatus which are thus employed in prior art production steps for substrates are usually adapted to individually create inspection data such as standard reference values for evaluating data set in an inspection area or measured data obtained in such an inspection area and to carry out an inspection routine according to an independent algorithm. It also happens frequently with modem inspection apparatus to set an inspection area based on substrate design data such as CAD data on the premise that the printed circuit board has been created exactly according to its design. In the inspection process after the solder printing step, for example, an image of a solder piece may be extracted from an inspection area to measure its area and position, these measured values being compared with standard values based on the design data. In reality, however, there are small fluctuations in the positions of lands due to displacements of resist material in the production step of printed circuit boards, and the position and the size of a land are not always exactly the same as described as the design data.

On the other hand, the density of components mounted on each substrates is increasing and, as components are made smaller, the lands on the substrates, too, tend to become smaller. Thus, if the solder is printed away from its intended land position even by a small distance, there is the danger of making it very difficult to mount and solder a component properly. If standard reference values for evaluating an inspection area are set on the basis of the substrate design data, it may be not possible to detect the displacement of a printed position of a solder piece. In the case of a substrate after the solder printing step, for example, although the solder is printed at a standard position according to the substrate design data, there is a possibility of displacement greater than an allowable limit between the land and the solder if the land is displaced from its standard position according to the substrate design data. At the inspection after the solder printing step, however, this displacement will not be detected because a judgment as a "good" product will be given as long as the solder is found to be printed at the standard position based on the substrate design data.

### Summary of the Invention

It is therefore an object of this invention in view of the problem described above to carry out an inspection properly by using data generated in an earlier production step.

An inspection method according to this invention for substrates having components mounted thereon and being produced by a plurality of sequentially performed production steps may be characterized as comprising the steps of providing a plurality of inspection apparatus each associated with different one of these production steps including the last of these production steps and carrying out an inspection process on a substrate by each of the inspection apparatus by using an image of this substrate taken after the production step associated therewith wherein each of the inspection apparatus, which is associated with one of the production steps carried out after another of these production steps having another of these inspection apparatus associated therewith, inputs data generated while this substrate was being inspected by this another inspection apparatus and uses the inputted data to inspect the substrate.

In the above, the production steps may include the steps of solder printing, component mounting and soldering. The step of producing printed circuit boards may or may not be included before the solder printing step. Even if an inspection apparatus is provided to this production step, this production itself is not necessary for practicing the method of this invention although inspection data obtained by inspecting printed circuit boards are received by inspection apparatus on the downstream side. In other words, the method of this invention may be used, for example, on printed circuit boards produced and purchased elsewhere. It is preferable to provide conveyers between pairs of these production steps but it is not a required element of the invention. These production steps may be physically separated one from another. Although it is desirable to associate an inspection apparatus with each of the production steps but it may be sufficient to provide one inspection associated with the last of the production steps and another associated to another production step.

Each of these inspection apparatus may be formed as an image-taking device having a camera, or a device making use of fluoroscopic images using X-rays. It also goes without saying that not all of the inspection apparatus are required to carry out a judgment-making process. Some of the inspection apparatus may be adapted only to obtain an image of the substrate that may be inputted to another inspection apparatus on the downstream side when requested.

It is desirable to connect these inspection apparatus with a network line such as a LAN line such that data necessary for the inspection can be inputted through such a line but the invention is not limited by such embodiments. Communications may be carried out among the inspection apparatus through wireless means or by providing a computer as a server. Instead, furthermore, data generated by an inspection may be stored on a specified memory medium such that the memory medium with stored data may be introduced to another inspection apparatus.

In the above, data need not be requested from the inspection apparatus associated with the production step immediately before, Data may be requested from a plurality of inspection apparatus for a single inspection process. The data on a target substrate may include the results of measurement carried out thereon or those data that had been extracted for an inspection. Image data created for inspection may also be included.
Such image data are not limited to density-varying images inputted by a camera but may also include binary images generated by a conversion process on a density-varying image and edge images. The image data may be those only of the area required by the inspection apparatus associated with a later production step carrying out the inspection.

By this method of inspection, each inspection apparatus on a downstream side can make use of the inspection data obtained on the actual target substrate being inspected by an inspection apparatus on the upstream side. Thus, a judgment can be made according to the specification of the actual target substrate and the data obtained by measurements can be utilized more effectively.

According to a preferred method of inspection, the plurality of inspection apparatus are adapted to communicate with one another, each of the inspection apparatus associated with one of the production steps before the last step is adapted to save in a memory those data that are generated during the inspection process for each of the inspected substrates, to respond to a request received from another inspection apparatus (on the downstream side) by retrieving requested data from the memory and to transmit the retrieved data to the inspection apparatus which made the request from the downstream side. The inspection apparatus on the downstream side inputs the transmitted data and carries out its inspection.

If the production steps include a circuit board producing step of producing printed circuit boards, the inspection apparatus associated with this production step is preferably adapted to extract position data of a land or data indicative of an area on which the land is formed and to input the extracted data to another inspection apparatus on the downstream side. The position data related to a land may relate to its representative point such as its center of gravity. Data indicative of the area of a land may comprise coordinates of the pixels inside the land or points on its edges. Since a land is usually rectangular, the coordinates of its four corner points may be used.

If the data thus extracted from the inspection apparatus associated with the circuit board producing step are inputted to the inspection apparatus associated with another inspection apparatus associated with the production step of carrying out solder printing (referred to as the solder printing step), the inspection apparatus associated with this solder printing step may be adapted to extract position data of solder or area data indicative of an area on which solder is printed and to judge correctness of the position data or the area data with reference to the inputted data. Explained more in detail, this is to compare the position of the solder with reference to the position of the land and to thereby evaluate the displacement of the printed solder or to compare the area of the solder with that of the land to evaluate whether the quantity of the solder on the land is adequate or not or to detect the quantity of solder which has spilled out of the area of the land.

If the data extracted from the inspection apparatus associated with the circuit board producing step are inputted to the inspection apparatus associated with another inspection apparatus associated with the step of mounting a component (referred to as the component mounting step) or the step of soldering (referred to as the soldering step), the inspection apparatus to which these extracted data are inputted may be adapted to extract from an image of the substrate data (referred to as component data) indicative of the position of a component or the area for mounting a component and to judge correctness of the component data with reference to the inputted data. Explained more in detail, this is to judge the correctness of the mounted position of a component with reference to that of a land or to determine a desirable area for a component based on the position of the land and to detect the positional and directional displacement of the component by checking whether the area extracted by the inspecting apparatus matches the determined desirable area.

If the data extracted from the inspection apparatus associated with the circuit board producing step are inputted to another inspection apparatus associated with the aforementioned soldering step, the inspection apparatus to which these extracted data are inputted may be adapted to set an inspection area for the substrate with reference to the inputted data and to judge correctness of soldering position by using an image within the inspection area. This is, for example, to extract a soldering position within a set inspection area based on the position of a land or an area for forming a land and to measure its position and size. In other words, a more accurate judgment can be made because the condition of the soldering position is judged according to an actual land.

If the production steps include the aforementioned circuit board producing step, the inspection method may further include the step of inputting an image used for inspection by the inspection apparatus associated with the circuit board producing step to another inspection apparatus on the downstream side for use in the inspection by the latter. For example, an image used by the inspection apparatus associated with the circuit board producing step may be inputted to the inspection apparatus associated with the aforementioned mounting or soldering step on the downstream side such that the latter inspection apparatus can judge the correctness of the condition of the mounted component by comparing the image of the target substrate with the inputted image.

If the production steps include the aforementioned solder printing step, the inspection apparatus associated with the solder printing step may be adapted to extract position data of solder or area data indicative of an area on which solder is printed and to input these extracted data to another inspection apparatus on the downstream side. If these extracted data are inputted to the inspection apparatus associated with the aforementioned component mounting step, the latter inspection apparatus may be adapted to input the data extracted by the inspection apparatus associated with the solder printing step, to extract component data indicative of position of a component or area at which a component is mounted from an image of the target substrate, and to judge correctness of the extracted component data based on the inputted data.

If the production steps include the aforementioned solder printing step, furthermore, the inspection method may further include the step of inputting an image used for inspection by the inspection apparatus associated with the solder printing step to another inspection apparatus on the downstream side for use in the inspection by the latter. For example, an image used by the inspection apparatus associated with the solder printing step may be inputted to the inspection apparatus associated with the aforementioned mounting step on the downstream side such that the latter inspection apparatus can judge the correctness of the condition of the mounted component by comparing the image of the target substrate with the inputted image.

An inspection method according to this invention may alternatively be characterized as comprising the step of providing an inspection apparatus as described above at least to the last of the plurality of production steps for substrates. In other words, the invention teaches that it may be sufficient if an inspection process is carried out at the last of the production steps although the invention does not intend to limit the number of inspections to be carried out to one and two or more inspection steps may be carried out, as described above. As an example, the inspection method further comprises the steps of taking an image of a substrate before the last production step after an earlier production step has been carried out on the substrate, extracting from this image a characteristic of the substrate resulting from this earlier production step and using this extracted characteristic for inspection of the substrate by the inspection apparatus associated with the last production step.

In the above, the "earlier production step" does not necessarily mean the production step which is immediately before the last production step. For example, if the production steps include the solder printing step, the component mounting step and the soldering step, an associated inspection apparatus may be provided to each of these production steps. The "characteristic" of the substrate "resulting" from such an earlier production step may be any physical characteristic acquired by the substrate as a result of carrying out this earlier production step. If the earlier production step is the aforementioned circuit board producing step, for example, the characteristic resulting from this production step may relate to a land formed on the substrate. If the aforementioned solder printing step is the earlier production step, the acquired characteristic may relate to the cream solder printed on the substrate. If the component mounting step is the earlier production step, the acquired characteristic may relate to a mounted component. By such a method as described above, therefore, correctness related to cream solder, a component or a solder fillet may be inspected with reference to a characteristic acquired prior to the production step to which an inspection apparatus is associated. For example, correctness of the quantity of solder, displacement of a component and the condition of a formed solder fillet may be judged with reference to a land.

As another example, the inspection method may comprise the steps of taking an image of a substrate before the last production step after an earlier production step has been carried out on the substrate, saving this image and inputting this saved image to the inspection apparatus for carrying out inspection of this substrate.

The invention relates also to an inspection system for substrates having components mounted thereon and being produced by a plurality of sequentially performed production steps, characterized as comprising a plurality of inspection apparatus each associated with different one of these production steps including the last of the production steps wherein each of the inspection apparatus associated with one of the production processes on the upstream side of the last production step comprises data storing means for storing in a memory for each substrate those data that were generated during inspection thereby and data transmitting means for receiving a request from another of the inspection apparatus on the downstream side, retrieving requested data according to the request from the memory and transmitting the retrieved data to the inspection apparatus which made this request, and wherein each of the inspection apparatus having another of these inspection apparatus on the upstream side comprises request transmitting means for transmitting a request for data on the substrate to another of the inspection apparatus on the upstream side and processing means for carrying out inspection of the substrate by using data received in response to this transmitted request.

Each of these inspection apparatus may be formed as an image-taking device having a camera, or a device making use of fluoroscopic images using X-rays. The data storing means, the data transmitting means, the request transmitting means and the processing means may each be formed as a computer with a program installed for carrying out its function.

In the above, it is preferable to provide each of these inspection apparatus further with means for recognizing identification data related to the substrate to be inspected, say, by extracting an ID code attached to the substrate from the image being inspected. Such an ID code may comprise a bar code, a two-dimensional code or a character array and may preferably be attached at a specified position on the substrate.

With an inspection system thus structured, whenever any of the series of inspection apparatus associated with other than the last one of the series of the production processes for substrates completes its inspection, the data created by the inspection (such as results of the inspection, measured data and image data) can be stored in a memory corresponding to the ID code of the substrate. A request for such data may be transmitted as a message including the ID code and the inspection apparatus which received such a request can retrieve the requested data accordingly and transmit them back in response. The inspection apparatus that transmitted the request can thus make use of the returned data in its own inspection process including processes such as setting an inspection area and comparing measured and/or image data.

The invention further relates to a method of producing mounted substrates by carrying out a plurality of production steps sequentially. The method according to this invention is characterized as using a system as described above by providing a plurality of inspection apparatus each associated with different one of these production steps including the last of these production steps and carrying out an inspection process on a substrate by each of these inspection apparatus by using an image of the substrate taken after the production step associated therewith and also as described above.

In the above, the plurality of production steps may include the solder printing, component mounting and soldering steps. The aforementioned circuit board producing step may also be included before the solder printing step. It is preferable to connect the solder printing, component mounting and soldering steps mechanically, say, by means of conveyer belts such that an integrated production line can be formed. Although the circuit board producing step may be separated from such a production line, the inspection apparatus associated with this step may be set at the head of the production line.

According to this invention, inspections can be carried out more reliably because each time a substrate being produced is inspected during its production processes, an image of the same substrate or data produced in an earlier executed production step are used.

### Brief Description of the Drawings

Fig. 1 is a schematic diagram of a production line for substrates to which the present invention is applied.
Fig. 2 shows an example of image of a bare substrate.
Fig. 3 is a block diagram of an inspection apparatus.
Fig. 4 is an example of data extracted by the bare substrate inspecting apparatus.
Fig. 5 is an example of data extracted by the solder printing inspecting apparatus.
Fig. 6 is an example of data extracted by the component mounting inspecting apparatus.
Fig. 7 shows an example of Inspection (1).
Fig. 8 shows an example of Inspection (2).
Fig. 9 shows an example of Inspection (3).
Fig. 10 shows an example of Inspection (4).
Fig. 11 shows an example of Inspection (5).
Fig. 12 shows an example of Inspection (8).
Fig. 13 is a flowchart of the inspection process.

### Detailed Description of the Invention

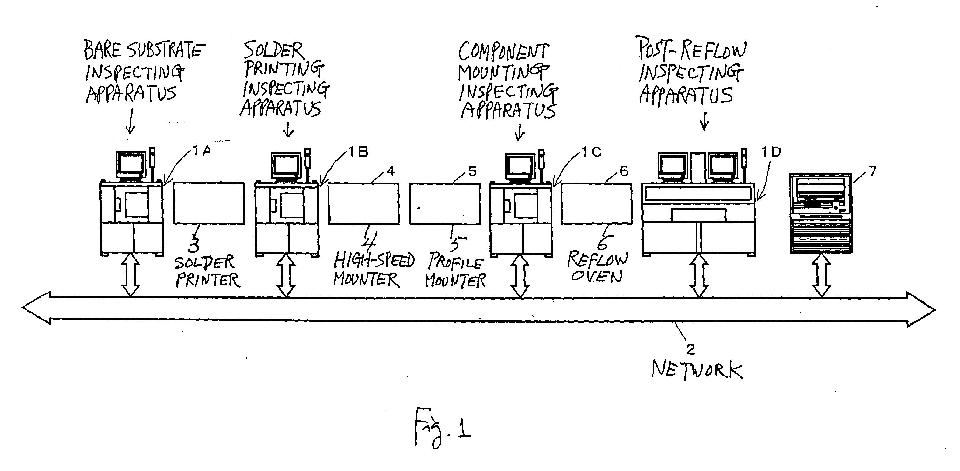

Fig. 1 shows a production line for substrates to which the present invention is applied, including production apparatus such as a solder printer 3, a high-speed mounter 4, a profile mounter 5 and a reflow oven 6, a plurality of inspection apparatus 1 and a data processor 7. The inspection apparatus 1 are set at four different positions, one (indicated by symbol 1A) on the upstream side of the solder printer 3, another (indicated by symbol 1B) between the solder printer 3 and the high-speed mounter 4, a third (indicated by symbol 1C) between the profile mounter 5 and the reflow oven 6, and a fourth (indicated by symbol 1D) on the downstream side of the reflow oven 6.

The data processor 7 is a computer having a hard disk with a large capacity and may have a terminal device (not shown) such as a personal computer connected to it. Each of the inspection apparatus and the data processor 7 are set such that they can communicate among themselves through a network line 2 such as a LAN line. The individual inspection apparatus 1 are arranged in the order shown in Fig. 1 and are connected by conveyers (not shown) for transporting substrates.

The solder printer 3 is adapted to receive a supply of printed circuit board and to carry out a solder printing process by applying cream solder at soldering positions on each component. The high-speed mounter 4 is for mounting chip components at a high speed and the profile mounter 5 is for mounting components other than chip components, that is, the component mounting processes are carried out by these two mounters 4 and 5. The reflow oven 6 is for carrying out a soldering process by heating the substrate after the component mounting processes.

The inspection apparatus 1A on the upstream side of the solder printer 3 (the bare substrate inspecting apparatus) is for inspecting the positions and sizes of the lands and the condition of silk printing on a bare substrate (or a substrate before the solder printing process is carried out but having silk printing patterns and lands already formed thereon). The inspection apparatus 1B between the solder printer 3 and the high-speed mounter 4 (the solder printing inspecting apparatus) is for inspecting the condition of the applied solder on a substrate which has just gone through the solder printing process. The inspection apparatus 1C between the profile mounter 5 and the reflow oven 6 (the component mounting inspecting apparatus) is for inspecting the presence and absence of components, their displacements and appropriateness of their orientations on a substrate which has just gone through the component mounting process. The inspection apparatus 1D on the downstream side of the reflow oven 6 (the post-reflow inspecting apparatus) is not only for judging appropriateness of solder fillets formed by the heating process on a substrate which has just gone through the soldering process by the reflow oven 6 but also for carrying out an inspection similar to the one done by the component mounting inspecting apparatus 1C.

Each of these inspection apparatus 1 is provided with a CCD camera (not shown) for obtaining a color image and a holder stage for supporting a substrate and carries out an inspection by viewing by using the image of the substrate obtained by the camera. Each of these inspection apparatus 1 carries out preliminary processes prior to carrying out an inspection for teaching set data for an inspection area, a binarization threshold value needed for extracting the color of a target portion of inspection (which is the solder for the solder printing inspecting apparatus 1B and the component for the component mounting inspecting apparatus 1C), a program for inspecting the extracted target portion of inspection extracted by using this binarization threshold value and a standard value to be compared with measured data obtained from the target portion of inspection. These data that are taught for these inspections are hereinafter referred to as the inspection data.

The data processor 7 stores the measured data and results of inspections received from each of the inspection apparatus 1. When a defect occurs among the substrates, the stored data immediately before and after the occurrence are analyzed and the data processor 7 carries out the process of correcting the inspection data to be used by each of the inspection apparatus 1 based on the results of this analysis. The corrected inspection data are transmitted to each of the inspection apparatus 1, and each inspection apparatus 1 updates the inspection data registered to itself in response.

Bare substrates are produced in a production process for printed circuit boards not shown in the figure. In this production process, a bar code is attached to each produced board for its identification and marks for its positioning are formed at the left-hand bottom and right-hand top corners.

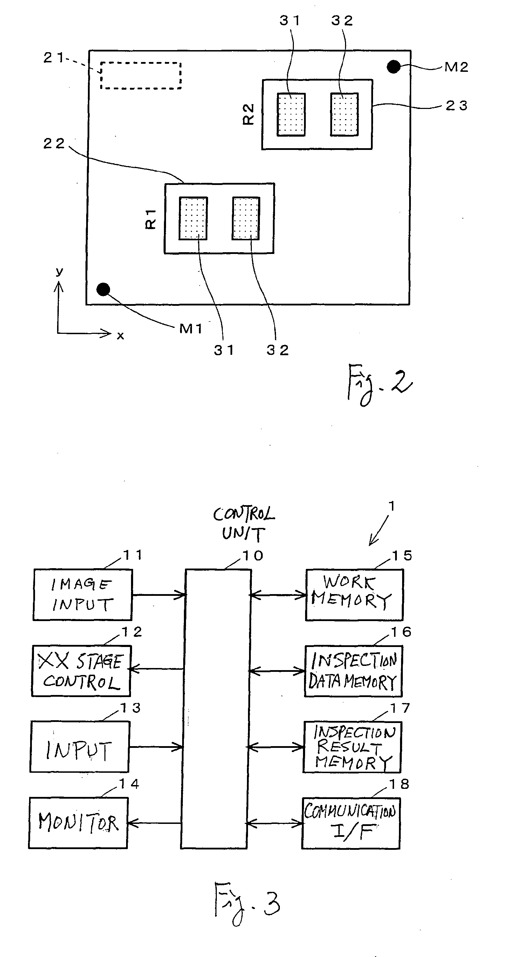

Fig. 2 shows an example of image of a bare substrate. For simplifying the explanation, this is an example with only two components to be mounted and the areas for their mounting are shown enlarged.

In Fig. 2, numeral 21 indicates the area wherein the aforementioned bar code label is pasted. M1 and M2 indicate the positioning marks, and character arrays R1 and R2 indicate component codes. These character arrays R1 and R2 and their surrounding frames 22 and 23 are all formed by a silk printing process. The frames 22 and 23 indicate areas each allocated to a component at the time of designing the substrate and designed to be large enough to include the corresponding component and lands therefor. Each of the inspection apparatus 1 is adapted to set its inspection areas after obtaining an image of the target substrate to be inspected by using these frames 22 and 23 on the image. In this example, chip components are mounted inside these frames 22 and 23. Since Fig. 2 is an image of a bare substrate before solder and components are placed thereon, the total images of lands 31 and 32 to be connected to the electrodes on both ends of each chip component are shown.

Each of the inspection apparatus 1 according to this example is formed to carry out inspections while communicating with the others of the inspection apparatus 1 and the data processor 7 through the network line 2. The solder printing inspecting apparatus 1B, the component mounting inspecting apparatus 1C and the post-reflow inspecting apparatus 1D, in particular, are adapted to carry out their inspection processes by receiving data necessary for the inspection from the inspection apparatus 1 on the upstream side and using such received data, as a target substrate to be inspected is received on the holder stage.

In what follows, the structure and an example of inspection to be carried out will be described for each of the inspection apparatus 1.

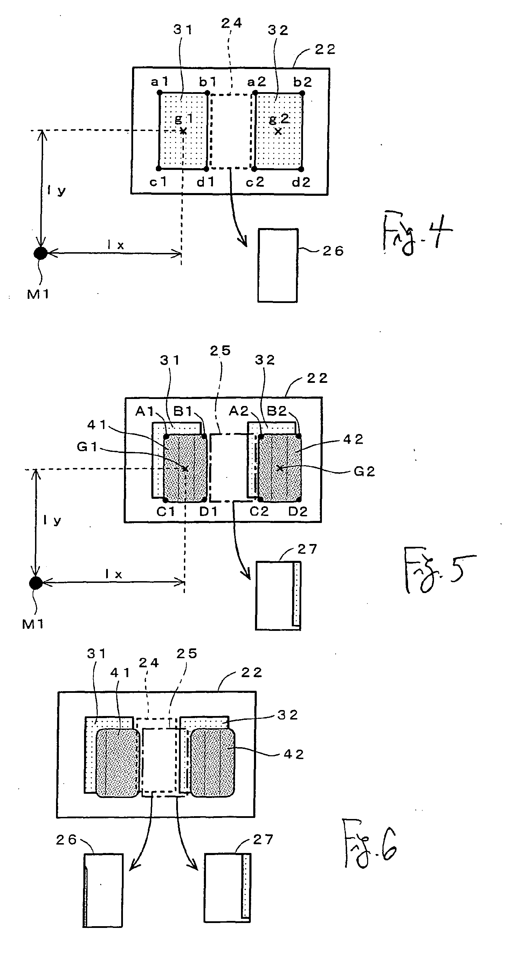

Fig. 3 shows the common structure of the inspection apparatus 1, including a control unit 10 comprised of a computer to which an image input part 11, an XY stage control part 12, an input part 13, a monitor 14, a work memory (RAM) 15, an inspection data memory 16, an inspection result memory 17 and a communication interface 18 are connected. The control unit 10 includes not only a CPU but also a ROM that stores basic programs.

The image input part 11 includes an interface circuit and an A/D converter circuit for image input and digital images created thereby are stored in the work memory 15. The XY stage control part 12 is for controlling the positions of the aforementioned holder stage for the substrate and the holder for the camera in response to commands from the control unit 10 such that the camera is positioned for a preliminarily determined target area. The input part 13 includes a keyboard and a mouse and is used at the time of an inspection for inputting the type of the substrate to be inspected or at the time of teaching for inputting various set data. The monitor 14 is used for displaying the user interface at the time of teaching, the target image of inspection and the results of inspection.

The inspection data memory 16 is a memory for storing the aforementioned inspection data. The inspection data are made into files according to the kinds of substrate. At the time of an inspection, the name of the desired kind of substrate is inputted and the inspection data file corresponding to such input are read out and set in the work memory 15.

The inspection result memory 17 is for saving the data obtained by inspection for each substrate and is comprised of a hard disk device with a large capacity. In the present example, not only the results of inspection but also results of measured color patterns (such as position and size data on patterns) extracted by the aforementioned binarization threshold value and image data of substrates used for the inspection are also stored in the inspection result memory 17. When data are stored in the inspection result memory, a folder is set for each substrate having the identification code of the substrate as its folder name and data in the form of a file may be stored in this folder for each inspected portion.

The communication interface 18 is for communicating with the others of the inspection apparatus 1 and the data processor 7 through the network line 2.

The post-reflow inspecting apparatus 1D is comprised additionally of a light-projecting part (not shown) including red, green and blue ring-shaped light sources. This light-projecting part is for the purpose of inspecting the slope condition of a fillet. Each light source has a different diameter and is set such that light beams of different colors therefrom will irradiate the substrate at different angles of elevation. The aforementioned camera is set such that its optical axis passes through the center of each light source and is oriented vertically. Since molten solder has an enhanced mirror surface characteristic, large portions of the color light beams from the light sources are mirror-reflected by the surface of the fillet. Thus, the color of light received by the camera will be different, depending on the slope angle of the reflecting surface. On the fillet portion of the image created by the post-reflow inspecting apparatus 1D, a distribution of color areas in the order of red-green-blue will appear along the direction in which the slope changes. The post-reflow inspecting apparatus 1D serves to extract each color area from the image of a target substrate, to measure the area and the size of each area and compare the measured values from preliminarily registered standard values, and to thereby judge the size and the slope condition of the fillet. The principle of inspection of a fillet in this manner is described more in detail, for example, in Japanese Patent Publication Tokko 6-1173.

In the substrate production line structured as explained above, all of the inspection apparatus 1 except for the bare substrate inspecting apparatus 1A are each characterized as receiving data saved in the inspection result memory 17 of the inspection apparatus 1 for the previous production step and carrying out its own inspection by using such received data. The control unit 10 of each inspection apparatus 1 is provided with a color tone correcting function by which a correction is made based on parameters preliminarily obtained by comparing images obtained by the different inspection apparatus such that the difference in brightness and coloring of images at different inspection apparatus 1 will be within an allowable range.

Table 1 shows the kinds of data obtained by each of the inspection apparatus 1 and Table 2 shows the correlation between the details of inspection by each inspection apparatus and the data (inclusive of both the data obtained from the apparatus on the upstream side and the data extracted by itself) that are used for each kind of inspection. As for the bare substrate inspecting apparatus 1A, since it has no inspection apparatus on its upstream side, it carries out inspections without using any data received from a different one of the inspection apparatus 1.

**Table 1**

| Inspection apparatus | Data to be obtained |
|---|---|
| Bare substrate inspecting apparatus | (a) Land position and size data (coordinates of pixels) |
| | (b) Center of gravity of land (obtained from (a)) |
| | (c) Four corners of land (obtained from (a)) |
| | (d) Images between land positions (obtained from (a) and (c)) |
| Solder printing inspecting apparatus | (e) Solder position and size data (coordinates of pixels) |
| | (f) Center of gravity of solder (obtained from (e)) |
| | (g) Four corners of solder (obtained from (e)) |
| | (h) Images between solder positions (obtained from (e) and (g)) |
| Component mounting inspecting apparatus | (i) Images between land positions (obtained from (a) and (c)) |
| | (j) Images between solder positions (obtained from (e) and (g)) |
| Post-reflow inspecting apparatus | (k) Images between land positions (obtained from (a) and (c)) |

**Table 2**

| Inspection apparatus | Details of inspection | Data that are used |
|---|---|---|
| Solder printing inspecting apparatus | (1) Solder displacement | (b) and (f) |
| | (2) Solder quantity (area) | (a) and (e) |
| | (3) Solder spilling over from land | (a) and (e) |
| Component mounting inspecting apparatus | (4) Presence/absence of components | (d) and (i), or (h) and (j) |
| | (5) Displacements of components | (c) or (g) |
| Post-reflow inspecting apparatus | (6) Presence/absence of components | (d) and (k) |
| | (7) Displacements of components | (c) |
| | (8) Fillet inspection | (a) or (c) |

Every time a target substrate is inspected, each of the inspection apparatus 1 extracts data as shown in Table 1 from the image (referred to as the target image) obtained from the target substrate. The extracted data are not only used for the inspection by the same inspection apparatus which obtained the target image but also thereafter saved in the inspection data memory 16. If a demand is received thereafter from another inspection apparatus on the downstream side, the required data are retrieved and transmitted to the apparatus which issued the demand. The apparatus that issued the demand, upon receiving the transmitted data, uses them for the inspection by itself.

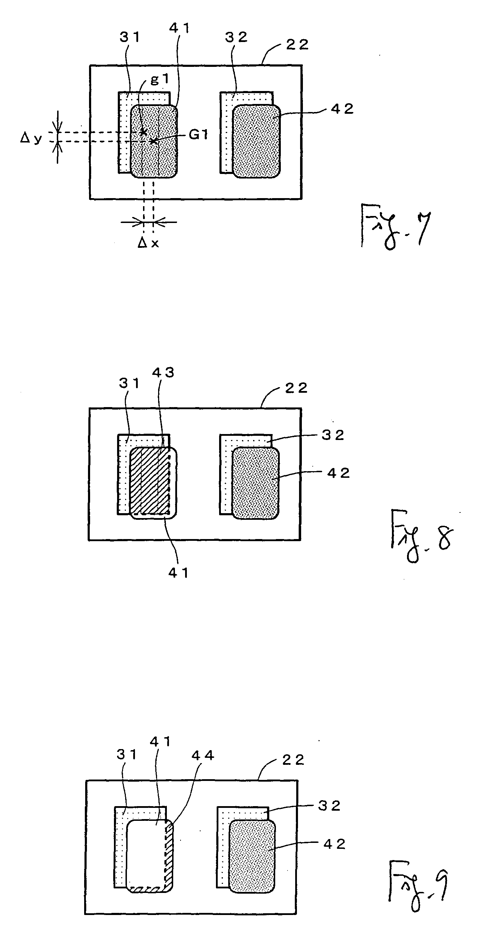

Fig. 4 shows an example of data extracted by the bare substrate inspecting apparatus 1A. It is hereby reminded that in each of Figs. 4-13, the image extracted from inside the frame 22 (shown in Fig. 2) will be shown for each of the inspection apparatus 1 with the corresponding images and areas indicated by the common symbols.

As shown in Table 1, the bare substrate inspecting apparatus 1A extracts four kinds of data (a), (b), (c) and (d) which are hereinafter referred to respectively as Data (a), Data(b), Data (c) and Data (d). Data (a) are for indicating the positions and sizes of lands. According to the illustrated example, the target image is binarized, two lands 31 and 32 are extracted and the coordinates of the pixels comprising each of these two lands 31 and 32 are obtained. This assembly of coordinates is referred to as Data (a).

Data (b) comprise the coordinates of the centers of gravity g1 and g2 of the lands 31 and 32, calculated by using the coordinates of the constituent pixels obtained as Data (a).

Data (c) comprise the coordinates of the points at the four corners of each of the lands 31 and 32 (or points a1, b1, c1 and d1 for land 31 and points a2, b2, c2 and d2 for land 32). In this example, those of the pixels forming the edges of the lands 31 and 32 are extracted by using Data (a), four straight lines are obtained by setting approximating straight lines based on these pixels and crossing points of these four straight lines are calculated as the four corner points of the corresponding land.

Data (d) comprise the image of an area between the lands 31 and 32. According to the illustrated example, an area 24 having a width and a length approximately equal to the distance between the lands 31 and 32 and their length is defined between the lands 31 and 32 and an image 26 of this area 24 is extracted as Data (d).

All of the coordinates included in Data (a), (b) and (c) are replaced by relative coordinates with reference to the aforementioned left-hand bottom corner mark M1. The center of gravity g1 being considered as an example, its coordinates are (1x, 1y), as shown in Fig. 4. The others of the inspection apparatus 1 also define the coordinates of various points with respect to the same corner mark M1 such that the coordinates will match among the inspection apparatus 1. It is also to be noted that the images obtained as Data (d) are not binarized images but density-varying color images comprising R, G and G gradation data. This is the same for Data (h)-(k).

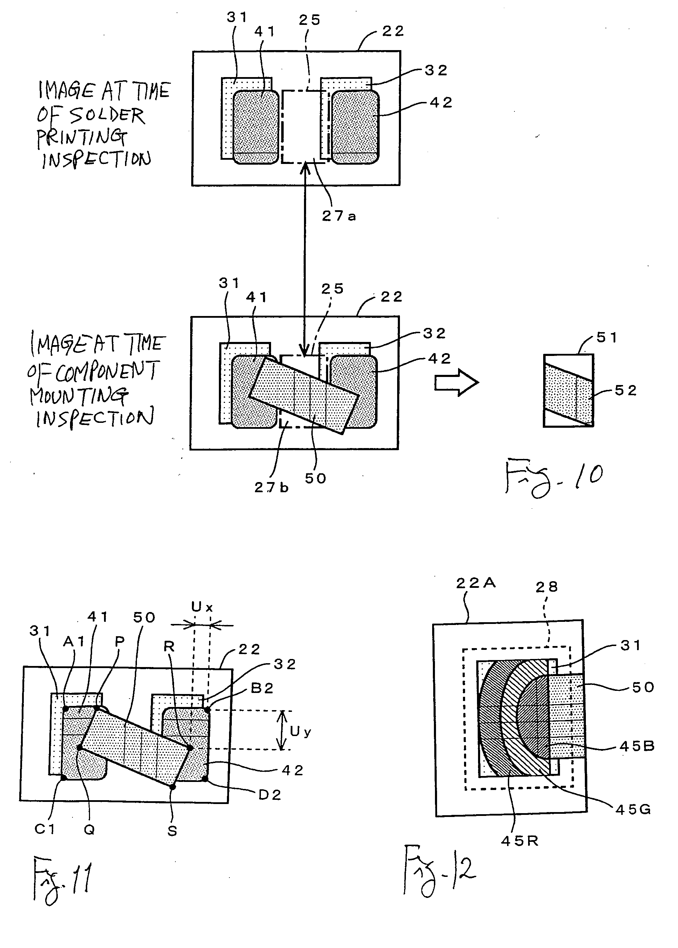

Fig. 5 shows an example of data extracted by the solder printing inspecting apparatus 1B. As shown in Table 1, the solder printing inspecting apparatus 1B is adapted to extract the four kinds of data (e), (f), (g) and (h) which are hereinafter referred to as Data (e), Data (f), Data (g) and Data (h).

Data (e) represent the positions and the sizes of solder pieces. According to the illustrated example, solder pieces 41 and 42 on the target image are extracted by binarization, as explained above regarding Data (a) extracted by the bare substrate inspecting apparatus 1A. The coordinates of the constituent pixels are obtained for each of the solder pieces 41 and 42 and the assembly of these coordinates is referred to as Data (e).

Data (f) comprise the coordinates of the centers of gravity of the solder pieces 41 and 42 which are calculated by using Data (e). Data (g) comprise the coordinates of the four corner points each of the solder pieces 41 and 42 (points A1, B1, C1 and D1 regarding solder piece 41, and points A2, B2, C2 and D2 regarding solder piece 42). The coordinates of these points are calculated in the same way as done for Data (c), that is, by setting four straight lines approximating the edges of each solder piece and obtaining the crossing points of these straight lines. Data (e) are used for these calculations, too.

Data (h) comprise the image of an area between the solder pieces 41 and 42.
According to the illustrated example, an area 25 is defined between the solder pieces 41 and 42 based on Data (e) and (g) and by using a technique similar to the one used for Data (d) regarding the bare substrate inspecting apparatus 1A and an image 27 of this area 25 is extracted as Data (h).

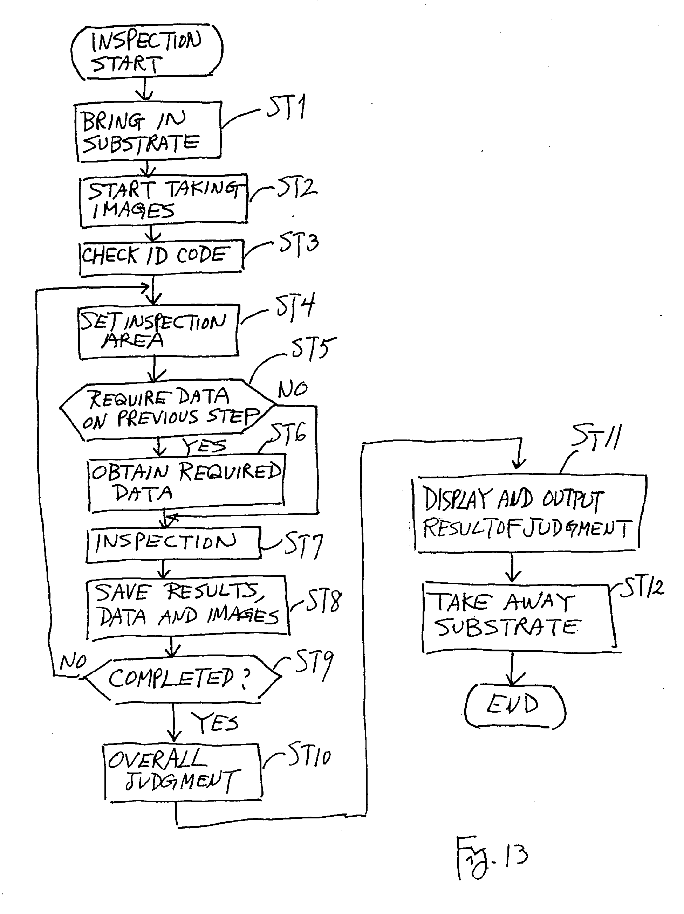

Fig. 6 shows an example of data extracted by the component mounting inspecting apparatus 1C. For clearly showing the range of extracted data, components that are mounted are not illustrated in Fig. 6.

As shown in Table 1, the component mounting inspecting apparatus 1C is adapted to extract the two kinds of data (i) and (j) which are hereinafter referred to as Data (i) and Data (j).

Data (i) comprise the image of an area between lands. According to the present example, an area 24 is set by using Data (a) and (c) from the bare substrate inspecting apparatus 1A and as done by the bare substrate inspecting apparatus 1A and an image 26 of this area 24 is extracted as Data (i). The coordinates of the constituent pixels of the area 24 extracted as Data (d) were extracted by the bare substrate inspecting apparatus 1A may be saved such that Data (i) can be extracted by the component mounting inspecting apparatus 1C by obtaining these saved coordinates.

Data (j) comprise the image of an area between solder pieces. According to the present example, an area 25 is set by using Data (e) and (g) from the solder printing inspecting apparatus 1B and as done by the solder printing inspecting apparatus 1B and an image 27 of this area 25 is extracted as Data (j). The coordinates of the constituent pixels of the area 25 extracted as Data (h) were extracted by the solder printing inspecting apparatus 1B may be saved such that Data (j) can be extracted by the component mounting inspecting apparatus 1C by obtaining these saved coordinates.

As also shown in Table 1, the post-reflow inspecting apparatus 1D is adapted to extract data (k) which are hereinafter also referred to as Data (k). Data (k) comprise the image of an area between the lands and since they can be extracted in the same manner as Data (i) by the component mounting inspecting apparatus 1C as explained above, this will not be separately illustrated. In addition, the post-reflow inspecting apparatus 1D serves to extract red, greed and blue color data for the aforementioned fillet inspection.

Next, the eight kinds of inspection described in Table 2 are explained. These eight kinds of inspection are hereinafter referred to respectively as Inspections (1)-(8).

The solder printing inspecting apparatus 1B carries out Inspections (1), (2) and (3) with cream solder placed on the lands treated as target portions. Inspection (1) is carried out for judging whether the solder is displaced or not. If there is a large displacement of solder with respect to the corresponding land, an appropriate fillet may not be formed because of the insufficiency of solder although a component is placed thereon and the reflow process is carried out thereafter. As a result, the electrical contact between the land and the component may become insufficient. It is in view of such a possibility that the process of inspecting the displacement of solder is carried out after the soldering process before the next production process is started.

Fig. 7 shows an example of process carried out in Inspection (1). Data (b) supplied from the bare substrate inspecting apparatus 1A and Data (f) obtained by the solder printing inspecting apparatus 1B itself are used for this process. Explained more in detail, the differences Δx and Δy respectively in the x-coordinates and the y-coordinates of the centers of gravity of each pair of mutually corresponding land and solder piece are calculated. For the sake of convenience, Fig. 7 shows only the measured results on the pair of land 31 and solder piece 41 but similar calculations are carried out also for the other pair of land 32 and solder piece 42. These difference values Δx and Δy are individually compared with a specified threshold value. If either of these difference values is found to exceed the corresponding threshold value, it is judged that there is an excessive displacement.

Inspection (2) is for the purpose of ascertaining whether or not a sufficient amount of solder has been placed on each land because a fillet cannot be formed properly by the soldering process if there is not sufficient solder and an insufficient contact may result.

Fig. 8 shows an example of process carried out in Inspection (2). Data (a) supplied from the bare substrate inspecting apparatus 1A and Data (e) obtained by itself are used for this process. Explained more in detail, pixels that are contained in both Data (a) and (e) are extracted such that the portion of the area on the land 31 where the solder piece 41 is carried (hereinafter referred to as solder-carrying area 43) is extracted. Next, the ratio between the size of this solder-carrying area 43 and the total area of the land 31 is calculated and compared with a specified threshold value. If the calculated ratio is smaller than the threshold value, it is judged that there is not sufficient solder.

Although Fig. 8 does not show, a solder-carrying area is similarly extracted from the other land 32 and a judgment is made as to the sufficiency of solder piece 42 on the land 32.

Inspection (3) is for checking whether a too large quantity of solder is not spilling outside each land because if too much solder spills out of a land, the spilled-out portion of the solder tends to solidify in the shape of a ball after the soldering process, resulting in a defective product, say, by contacting the land for the neighboring component.

Fig. 9 shows an exemplar process carried out in Inspection (3). This process, too, is carried out by using Data (a) supplied from the bare substrate inspecting apparatus 1A and Data (e) obtained by itself. In Inspection (3), pixels contained in Data (e) but not in Data (a) are extracted such that the area covered by the spilled-out portion of the solder outside the land (hereinafter referred to as spilled solder area 44) is extracted. Next, the size of this spilled solder area 44 is obtained and compared with a specified threshold value. If the calculated size of the spilled solder area 44 exceeds the threshold value, it is concluded that a too large quantity of solder is spilled over.

Although Fig. 9 does not show, a spilled solder area is similarly extracted from the other land 32 and a judgment is made as to the quantity of spilled-out solder.

According to a prior art method of inspecting solder printing, an inspection window was set according to substrate design data so as to include a land and a measurement process was carried out for inspection within this window. For this reason, if the land is displaced from its standard position based on the substrate design data although solder is at its standard position according to the substrate design data, such that the relative displacement between the land and the solder is in excess of an allowable upper limit, such a displacement could not be detected. If both the land and the solder are displaced in the same direction such that the solder is properly carried on the land, on the other hand, such a product is rejected as being defective if the solder is displaced from its standard position according to the substrate design data.

By Inspections (1), (2) and (3) according to this invention, by contrast, the displacement of the solder, quantity of solder on the land and spilling out of the land are measured with reference to the actual position and size of the land. Thus, measured quantities properly showing the relationship with the actual land size and position can be obtained and a more meaningful inspection can be carried out on the condition of soldering.

It may be noted that Inspection (1) is a simple inspection method, while Inspection (2) and Inspection (3) are strict methods. The user is free to select, depending on the purpose, whether to carry out Inspection (1) which is easy to do or Inspection (2) or (3) which are more strict. As for Inspection (2) and Inspection (3), there is a possibility that a target substrate is judged to be good according to Inspection (2) but defective according to Inspection (3). Thus, if a strict inspection is required, both Inspection (2) and Inspection (3) may be required.

Inspection (4) by the component mounting inspecting apparatus 1C is for checking whether a component is mounted at each of the mounting positions. Inspection (5) is carried out on the components that have been determined to be present in Inspection (4) and is for the purpose of checking whether the component determined to be present is misplaced (inclusive of rotational displacement) or not with respect to the land or the solder piece because a component not properly placed may not be properly soldered.

Inspection (4) is carried out not only by receiving Data (d) extracted by the bare substrate inspecting apparatus 1A and Data (h) extracted by the solder printing inspecting apparatus 1B but also either Data (i) or (j) extracted by itself, the choice between Data (i) and (j) being dependent on whether Data (d) or Data (h) are supplied.

Fig. 11 shows the processes carried out in Inspection (4) for a case where Data (h) (an image of an area between solder pieces 41 and 42, indicated by symbol 27a) are received from the solder printing inspecting apparatus 1B and Data (j) corresponding thereto (indicated by symbol 27b in this example) are used.

In this example, the image 27a corresponding to Data (h) is one obtained from the target image at the solder printing process and hence no component is included in this image. On the other hand, Data (j) correspond to an image 27b of the same area as Data (h) of the image of the substrate after components are mounted. Thus, the portion included in Data (j) but not included in Data (h) may be considered to correspond to a component 50.

In the example of Fig. 11, a differential calculation process is carried out on the images 27a and 27b shown by Data (h) and (j) based on the principle described above and a characterizing portion 52 included in Data (j) but not included in Data (h) is extracted from a processed image 51. Next, the area of this extracted characterizing portion 52 is calculated and compared with a specified threshold value. If this calculated area exceeds the threshold value, it is concluded that a component is mounted. A similar process may be carried out by using Data (d) and Data (i) to compare an image between the lands 31 and 32.

In Inspection (5), not only the supply of Data (c) extracted by the bare substrate inspecting apparatus 1A or Data (g) extracted by the solder printing inspecting apparatus 1B is received, but each of the corner points P, Q, R and S of a component is extracted and the results of this extraction is compared with the supplied data.

Fig. 11 shows an example of process carried out in Inspection (5). In this example, Data (g) (the coordinates of the four corner points of a solder piece) are received from the solder printing inspecting apparatus 1B and the coordinates of points A1, C1, B2 and D2 at outside positions of the points included in Data (g) are compared with those of the corner points P, Q, R and S which are the closest to them.

The comparison of two corresponding points is carried out by calculating differences Ux and Uy between the x-coordinates and the y-coordinates of the two points. Although Fig. 11 shows only the calculation of differences between points B2 and R, similar calculations are also carried out between points A1 and P, between points C1 and Q and between points D2 and S. The calculated values of these differences are each compared to a specified threshold value. If any of the compared value is found to exceed the threshold value, it is concluded that the component 50 is misplaced.

Inspection (5) may be carried out similarly by using Data (c).

According to a prior art method of inspecting mounted components, an inspection window is set where a component is to be mounted according to the substrate design data and the image of the component is extracted within this window. For this reason, if a solder piece or a land is displaced from the standard position according to the substrate design data although the component is mounted at its standard position according to the substrate design data, the displacement of the component with respect to the solder or the land may not be detected. Even If the component is displaced in the same direction as the solder or the land such that the component is properly mounted, as another example, the mounting may be considered defective if the component is displaced from the standard position according to the substrate design data.

By Inspection (5), by contrast, the displacement of a component is judged with reference to the actual land or solder position extracted in an earlier production step. Thus, the condition of a mounted component can be inspected properly. Inspection (4), too, can be carried out more reliably since reference is made to an image of an area between real lands or real solder pieces extracted in an earlier production step.

In the inspection of a mounted component, the user is free to select whether the judgment should be made with the position of a land or a solder piece as a standard. Since the so-called self-alignment effect may be anticipated in the reflow process after the mounting process due to the surface tension of the solder when it is melted, if the component is properly mounted with respected to an area with printed solder, an adequate result of soldering may be expected. Thus, there is an expectation in the inspection of mounted components that it is sufficient to make a judgment with reference to the position of the solder. Since the target position of a component after the reflow process is the position of a land, there is also the opinion that a judgment should be made with the position of a land as the reference.

It is in view of the above that Data (c) and (d) from the bare substrate inspecting apparatus 1A or Data (g) and (h) are selectable as data to be used in Inspection (4) and (5). In view of the above, it is also possible to make the standard of judgment less stringent for Inspection (5) than for Inspection (7), to be discussed below.

Inspections (6) and (7) carried out by the post-reflow inspecting apparatus are similar to Inspections (4) and (5) carried out by the component mounting inspection apparatus 1C and hence detailed explanations will be omitted. Since it is desirable to carry out the inspection of components after the reflow process by using a land as the standard, Inspections (6) and (7) are carried out by using Data (c) and (d) from the bare substrate inspecting apparatus 1A.

Inspection (8) is for judging the condition of a fillet formed in the soldering step.
Since the relationship between the fillet and the land must be checked in Inspection (8), too, Data (a) and (c) are received from the bare substrate inspecting apparatus 1A. Fig. 12 shows an example of process carried out in Inspection (8). In this example, a portion 22A of the image inside the frame 22 (shown in Figs. 10 and 11) including the left-hand land 31 is shown enlarged.

In Inspection (8), an inspection window 28 large enough to include the land 31 is set inside the target image based on Data (a) and (c) supplied from the bare substrate inspecting apparatus 1A. Binarization is carried out for the image inside this window 28 for each of R, G and B gradations to extract color areas 45R, 45G and 45B. The area and position of each of these color areas 45R, 45G and 45B are measured and compared with corresponding threshold values to judge the condition of the slope of the fillet.

According to a prior art method of inspecting a fillet, an inspection window is set based on substrate design data and binarization is carried out for each of the pixels inside the window. For this reason, if a land is displaced, a fillet which is properly formed on this displaced land cannot be properly evaluated by an inspection based on the substrate design data. According to Inspection (8) of this invention, by contrast, a fillet formed on a land can be properly evaluated since a window is set according to the actual position and the size of the land.

Fig. 13 shows an inspection routine common to the solder printing inspecting apparatus 1B, the component mounting inspecting apparatus 1C and the post-reflow inspecting apparatus 1D. The routine shown in Fig. 13 is for processing only one substrate. When a plurality of substrates are processed, the routine shown in Fig. 13 must be repeated as many times as there are substrates to be inspected.

As a target substrate to be inspected is brought in by a conveyer (Step ST1), the camera position is set with respect to the substrate by means of the XY stage control part 12 and the image-taking process is started (Step ST2). An image of the bar code label on the substrate is taken first and the bar code in the image is decoded to identify the substrate (Step ST3).

Subsequent Steps ST4-ST9 are carried out while the camera and the stage are moved, whenever necessary, to take the images of target areas sequentially. To start, a target area is set for a target position based on inspection data (Step ST4) such that it is large enough, for example, to include the frames 22 and 23. The setting is done after the frames 22 and 23 are extracted from the image by referencing the extracted positions. Thus, each of the inspection apparatus 1 can set an inspection area of a same size at a same position. Since coordinates within this inspection area are replaced by relative coordinates with reference to the corner mark M1, they can be well matched among the inspection apparatus 1.

Next, it is determined, based on the inspection logic to be carried out inside this inspection area, if data from an earlier step are necessary or not (Step ST5). If such data are required (YES in Step ST5), a message is transmitted to such an inspection apparatus on the upstream side, specifying the kind of required data (Step ST6). Such a message includes the identification code of the substrate and the component codes of the components to be inspected. The addressee inspection apparatus 1, upon receiving such a message, retrieves the requested data out of its inspection result memory 17 and returns them to the inspection apparatus 1 which is carrying out the inspection.

After the required data are supplied, the intended inspection is carried out by using the received data (Step ST7). If no data are required to be transmitted from any inspection apparatus 1 on the upstream side (NO in Step ST5), Step ST6 is skipped and only data stored by itself are used for the inspection. Examples of inspection not requiring any data from any of the inspection apparatus 1 on the upstream side include the bridge inspection by the solder printing inspecting apparatus 1B and the component mounting inspecting apparatus 1C and the inspection of mounting errors by the component mounting inspecting apparatus 1C and the post-reflow inspecting apparatus 1D.

After the inspection work is completed, a file is created by correlating the results of the inspection, the data used for the inspection and the images corresponding to Data (d) and (h)-(k) with the component codes and stored in the inspection result memory 17 (Step ST8).

These steps are repeated for each target portion to be inspected. After all target portions are inspected (YES in Step ST9), the overall quality (good or bad) of the target substrate is judged (Step ST10) and the result of this judgment is displayed on the monitor 14 and outputted to the data processor 7 through the network line 2 (Step ST11). The target substrate is thereafter transported away (Step ST12) and the process is completed.

The routine carried out by the bare substrate inspecting apparatus 1A is the same as shown in Fig, 13 except that the processes of Steps ST5 and ST6 are not carried out.

It is to be noted that a message for requesting for data is transmitted whenever such data are found to be necessary. Thus, this routine is particularly convenient when different target areas to be inspected require data from different inspection apparatus 1. If it is known from the beginning that only data from a specified inspection apparatus 1 are to be required, all required data may be received from this specified inspection apparatus 1 and stored in the work memory 15 prior to the inspection work.

## Claims

1. An inspection method for substrates having components mounted thereon and being produced by a plurality of sequentially performed production steps, said inspection method comprising the steps of:
providing a plurality of inspection apparatus each associated with different one of said production steps including the last of said production steps; and
carrying out an inspection process on a substrate by each of said inspection apparatus by using an image of said substrate taken after the production step associated with said each inspection apparatus;
wherein each of said inspection apparatus, which is associated with one of said production steps carried out after another of said production steps having another of said inspection apparatus associated therewith, inputs data generated while said substrate was being inspected by said another inspection apparatus and uses said inputted data to inspect said substrate.

2. The inspection method of claim 1 wherein said plurality of inspection apparatus are adapted to communicate with one another;
wherein each of the inspection apparatus associated with one of said production steps before the last of said production steps is adapted to save in a memory data that are generated during said inspection process for each of said substrates, to respond to a request received from another of said inspection apparatus by retrieving requested data from said memory and to transmit said retrieved data to said another inspection apparatus; and
wherein said another inspection apparatus inputs said transmitted data and carries out inspection.

3. The inspection method of claim 1 wherein said production steps include a circuit board producing step of producing printed circuit boards and the inspection apparatus associated with said circuit board producing step is adapted to extract position data of a land or data indicative of an area on which a land is formed and to input said extracted data to another of said inspection apparatus on the downstream side.

4. The inspection method of claim 2 wherein said production steps include a circuit board producing step of producing printed circuit boards and the inspection apparatus associated with said circuit board producing step is adapted to extract position data of a land or data indicative of an area on which a land is formed and to input said extracted data to another of said inspection apparatus on the downstream side.

5. The inspection method of claim 3 wherein said production steps include a solder printing step of carrying out solder printing;
wherein said extracted data are inputted to the inspection apparatus associated with said solder printing step; and
wherein the inspection apparatus associated with said solder printing step extracts position data of solder or area data indicative of an area on which solder is printed and judges correctness of said position data or area data with reference to said inputted data.

6. The inspection method of claim 4 wherein said production steps include a solder printing step of carrying out solder printing;
wherein said extracted data are inputted to the inspection apparatus associated with said solder printing step; and
wherein the inspection apparatus associated with said solder printing step extracts position data of solder or area data indicative of an area on which solder is printed and judges correctness of said position data or area data with reference to said inputted data.

7. The inspection method of claim 3 wherein said production steps include a component mounting step and a soldering step;
wherein said extracted data are inputted to the inspection apparatus associated with said component mounting step or said solder step; and
wherein the inspection apparatus which inputted said extracted data extracts from an image of said substrate component data indicative of a position of a component or an area for mounting a component and judges correctness of said component data with reference to the inputted data.

8. The inspection method of claim 4 wherein said production steps include a component mounting step and a soldering step;
wherein said extracted data are inputted to the inspection apparatus associated with said component mounting step or said solder step; and
wherein the inspection apparatus which inputted said extracted data extracts from an image of said substrate component data indicative of a position of a component or an area for mounting a component and judges correctness of said component data with reference to the inputted data.

9. The inspection method of claim 3 wherein said production steps include a soldering step;
wherein said extracted data are inputted to the inspection apparatus associated with said solder step; and
wherein the inspection apparatus which inputted said extracted data sets an inspection area for said substrate with reference to said inputted data and judges correctness of soldering position by using an image within said inspection area.

10. The inspection method of claim 4 wherein said production steps include a soldering step;
wherein said extracted data are inputted to the inspection apparatus associated with said solder step; and
wherein the inspection apparatus which inputted said extracted data sets an inspection area for said substrate with reference to said inputted data and judges correctness of soldering position by using an image within said inspection area.

11. The inspection method of claim 1 wherein said production steps include a circuit board producing step of producing printed circuit boards and said inspection method further comprises the step of inputting an image used for inspection by the inspection apparatus associated with said circuit board producing step to another of said inspection apparatus associated with another of said production steps on the downstream side.

12. The inspection method of claim 2 wherein said production steps include a circuit board producing step of producing printed circuit boards and said inspection method further comprises the step of inputting an image used for inspection by the inspection apparatus associated with said circuit board producing step to another of said inspection apparatus associated with another of said production steps on the downstream side.

13. The inspection method of claim 11 wherein said production steps include a component mounting step and a soldering step;
wherein said image is inputted to the inspection apparatus associated with said component mounting step or said solder step; and
wherein the inspection apparatus that inputted said image judges correctness of the conditions of a mounted component by comparing an image of said substrate with said inputted image.

14. The inspection method of claim 12 wherein said production steps include a component mounting step and a soldering step;
wherein said image is inputted to the inspection apparatus associated with said component mounting step or said solder step; and
wherein the inspection apparatus that inputted said image judges correctness of the conditions of a mounted component by comparing an image of said substrate with said inputted image.

15. The inspection method of claim 1 wherein said production steps include a solder printing step of carrying out solder printing;
wherein the inspection apparatus associated with said solder printing step extracts position data of solder or area data indicative of an area on which solder is printed and inputs said extracted data to another inspection apparatus on the downstream side.

16. The inspection method of claim 2 wherein said production steps include a solder printing step of carrying out solder printing;
wherein the inspection apparatus associated with said solder printing step extracts position data of solder or area data indicative of an area on which solder is printed and inputs said extracted data to another inspection apparatus on the downstream side.

17. The inspection method of claim 15 wherein said production steps include a component mounting step; and
wherein the inspection apparatus associated with said component mounting step inputs the data extracted by the inspection apparatus associated with said solder printing step, extracts component data indicative of position of a component or area at which said component is mounted from an image of said substrate and judges correctness of the extracted component data based on the inputted data.

18. The inspection method of claim 16 wherein said production steps include component mounting step; and
wherein the inspection apparatus associated with said component mounting step inputs the data extracted by the inspection apparatus associated with said solder printing step, extracts component data indicative of position of a component or area at which said component is mounted from an image of said substrate and judges correctness of the extracted component data based on the inputted data.

19. The inspection method of claim 1 wherein said production steps include a solder printing step of carrying out solder printing and said inspection method further comprises the step of inputting an image used for inspection by the inspection apparatus associated with said solder printing step to another of said inspection apparatus associated with another of said production steps on the downstream side.

20. The inspection method of claim 2 wherein said production steps include a solder printing step of carrying out solder printing and said inspection method further comprises the step of inputting an image used for inspection by the inspection apparatus associated with said solder printing step to another of said inspection apparatus associated with another of said production steps on the downstream side.

21. The inspection method of claim 19 wherein said production steps include a component mounting step;
wherein said image is inputted to the inspection apparatus associated with said component mounting step; and
wherein the inspection apparatus that inputted said image judges correctness of the conditions of a mounted component by comparing an image of said substrate with said inputted image.

22. The inspection method of claim 20 wherein said production steps include a component mounting step;
wherein said image is inputted to the inspection apparatus associated with said component mounting step; and
wherein the inspection apparatus that inputted said image judges correctness of the conditions of a mounted component by comparing an image of said substrate with said inputted image.

23. An inspection method for substrates having components mounted thereon and being produced by a plurality of sequentially performed production steps, said inspection method comprising the steps of:
providing an inspection apparatus associated with the last of said production steps;
taking an image of a substrate before said last production step after an earlier production step has been carried out on said substrate;
extracting from said image a characteristic of said substrate resulting from said earlier production step; and
using said extracted characteristic for inspection of said substrate by said inspection apparatus associated with the last production step.

24. An inspection method for substrates having components mounted thereon and being produced by a plurality of sequentially performed production steps, said inspection method comprising the steps of:
providing an inspection apparatus associated with the last of said production steps;
taking an image of a substrate before said last production step after an earlier production step has been carried out on said substrate;
saving said image; and
inputting said saved image of said substrate by said inspection apparatus associated with the last production step for carrying out inspection of said substrate.

25. An inspection system for substrates having components mounted thereon and being produced by a plurality of sequentially performed production steps, said inspection system comprising a plurality of inspection apparatus each associated with different one of said production steps including the last of said production steps;
wherein each of the inspection apparatus associated with one of said production processes on the upstream side of the last production step comprises:
data storing means for storing in a memory for each substrate data that were generated during inspection thereby, and
data transmitting means for receiving a request from another of said inspection apparatus on the downstream side, retrieving requested data according to said request from said memory and transmitting said retrieved data to the inspection apparatus which made said request; and
wherein each of the inspection apparatus having another of said inspection apparatus on the upstream side comprises:
request transmitting means for transmitting a request for data on said substrate to another of said inspection apparatus on the upstream side, and
processing means for carrying out inspection of said substrate by using data received in response to said transmitted request.

26. A method of producing substrates having components mounted thereon, said method comprising the steps of:
carrying out a plurality of production steps sequentially;
providing a plurality of inspection apparatus each associated with different one of said production steps including the last of said production steps;
carrying out an inspection process on a substrate by each of said inspection apparatus by using an image of said substrate taken after the production step associated therewith;
wherein said plurality of inspection apparatus are adapted to communicate with one another;
wherein each of the inspection apparatus associated with one of said production steps before the last of said production steps is adapted to save in a memory data that are generated during said inspection process for each of said substrates, to respond to a request received from another of said inspection apparatus by retrieving requested data from said memory and to transmit said retrieved data to said another inspection apparatus; and
wherein said another inspection apparatus inputs said transmitted data and carries out inspection.
